# EUROPEAN PATENT SPECIFICATION

(11) **EP 4 564 680 B1**
(45) Date of publication and mention of the grant of the patent: **30.09.2026**
(21) Application number: 23856599.8
(22) Date of filing: 22.08.2023
(51) Int. Cl.: H03K 17/96, H03K 17/687, H03K 17/60, G06F 3/042, G06F 3/041

(54) **SIGNAL STRENGTH ADJUSTMENT CIRCUIT, INFRARED TOUCH-CONTROL APPARATUS AND ELECTRONIC DEVICE**
SIGNALSTÄRKENEINSTELLSCHALTUNG, INFRAROTBERÜHRUNGSSTEUERUNGSVORRICHTUNG UND ELEKTRONISCHE VORRICHTUNG
CIRCUIT DE RÉGLAGE D'INTENSITÉ DE SIGNAL, APPAREIL DE COMMANDE TACTILE INFRAROUGE ET DISPOSITIF ÉLECTRONIQUE

(30) Priority: 26.08.2022 CN 202211034854; 26.08.2022 CN 202222282111 U
(43) Date of publication of application: 04.06.2025
(73) Proprietor: Guangzhou Zhongyuan Intelligent Technology Co., Ltd., Guangzhou, Guangdong 510700 (CN)
(72) Inventor: QIN, Liang, Guangzhou, Guangdong 510700 (CN)
(74) Representative: Arnold & Siedsma
(86) International application number: PCT/CN2023/114189
(87) International publication number: WO 2024/041509

(56) References cited:
- CN-A- 112 799 551
- CN-A- 113 108 936
- CN-U- 210 627 166
- CN-U- 214 954 937
- CN-U- 214 954 937
- CN-U- 214 959 462
- CN-U- 218 850 753
- US-A1- 2021 242 774

## Description

The present disclosure claims the priority of Chinese patent application No. 202211034854.2 filed on August 26, 2022, entitled with "SIGNAL INTENSITY REGULATING CIRCUIT, INFRARED TOUCH DEVICE AND ELECTRONIC EQUIPMENT", and Chinese utility model application No. 202222282111.9 filed on August 26, 2022, entitled with "SIGNAL INTENSITY REGULATING CIRCUIT, INFRARED TOUCH DEVICE AND ELECTRONIC EQUIPMENT'.

### FIELD

The present disclosure relates to the technical field of electronic circuits, and in particular to a signal intensity regulating circuit, an infrared touch device, and an electronic equipment.

### BACKGROUND

On an interactive board or other touch devices, a touch circuit is usually provided to realize processing such as collection, filtering, and amplification of touch signals. A general touch control circuit includes a signal input circuit, a filter circuit, a signal regulating circuit and a controller which are electrically connected in sequence. The signal regulating circuit is composed of an analog switch chip, an operational amplifier and a matching resistor. Controlling the channel selection of the analog switch chip may regulate the signal amplification factor, thereby changing the signal intensity.

However, during the research and development process, the inventors of the present disclosure discovered that the regulation levels of the analog switch chip are limited by the limited number of channels inside the analog switch chip, and the regulation levels are only four to eight, which is a small number of regulation levels. Therefore, the regulatable fineness of the signal regulating circuit is affected. If more levels of regulation are required, multi-level chip cascading is required to achieve this, which results in a complex circuit structure and a high implementation cost.

Document CN214954937U describes a voltage division driving circuit for an infrared touch screen. The document describes a system that allows to control and adjust the output voltage of the infrared touch screen via conversion.

Document CN214959462U describes a gain adjustment circuit for an infrared touch screen that allows to control and adjust the output voltage of the infrared touch screen via gain adjustment.

### SUMMARY

In order to overcome the problems existing in the related art, the embodiments of the present disclosure provide a signal intensity regulating circuit, an infrared touch device and an electronic equipment. The signal intensity regulating circuit can make more fine regulation to the signal to be sampled, and has a simple circuit structure and is easy to implement.

According to a first aspect of an embodiment of the present disclosure, a signal intensity regulating circuit is provided, which includes a signal acquiring circuit, a controller and a signal regulating circuit; the signal regulating circuit is connected between the signal acquiring circuit and the controller; the controller has a signal input end and a control end;

the signal regulating circuit includes a switch element, the switch element has a first signal end, a second signal end and a controlled end;

the first signal end of the switch element is connected to the signal output end of the signal acquiring circuit to form a signal voltage-dividing node, the signal voltage-dividing node is connected to the signal input end of the controller, the second signal end of the switch element is connected to a reference power supply, and the controlled end of the switch element is connected to the control end of the controller;

the controller is configured to output a corresponding regulation signal to the controlled end of the switch element based on the touch sampling signal received at the current moment, the switch element is configured to generate a corresponding on-resistance based on the regulation signal, the signal voltage-dividing node is configured to form a touch sampling signal at the next moment under the voltage-dividing action of the output impedance of the signal acquiring circuit and the on-resistance, and transmit it to the signal input end of the controller.

According to a second aspect of the embodiments of the present disclosure, an infrared touch device is provided, which includes a signal intensity regulating circuit of any one of the above embodiments and an infrared signal receiving unit.

According to a third aspect of the embodiments of the present disclosure, an electronic equipment is provided, which includes an operating device and the infrared touch device of the above embodiment.

By applying the technical solution of the embodiment of the present disclosure, by providing a signal regulating circuit for regulating the touch sampling signal intensity between the signal acquiring circuit and the controller, the voltage of the touch sampling signal is regulated. When the controller outputs regulation signals of different voltages, on-resistances of different resistance values are generated inside the switch element of the signal regulating circuit. The on-resistance and the output impedance of the signal acquiring circuit form a voltage dividing circuit, thereby dividing the touch sampling signal to be sampled and forming touch sampling signals of different intensities at the current moment at the signal voltage-dividing node. The voltage value at the signal voltage-dividing node changes with the change of the regulation signal, thereby regulating the intensity of the touch sampling signal at the next moment with a relatively fine regulation degree.

It is to be understood that the above-mentioned general description and the following detailed description are exemplary and explanatory only and are not restrictive of the present disclosure.

For better understanding and implementation, the present disclosure is described in detail below with reference to the accompanying drawings.

### BRIEF DESCRIPTION OF THE DRAWINGS

Fig. 1 is a schematic block diagram of a signal intensity regulating circuit according to an embodiment of the present disclosure.
Fig. 2 is a schematic diagram of an output impedance of a signal acquiring circuit according to an embodiment of the present disclosure.
Fig. 3 is a circuit schematic diagram of a signal intensity regulating circuit according to Embodiment 1 of the present disclosure.
Fig. 4 is a circuit schematic diagram of a signal intensity regulating circuit according to Embodiment 2 of the present disclosure.
Fig. 5 is a circuit schematic diagram of a signal intensity regulating circuit according to Embodiment 3 of the present disclosure.
Fig. 6 is a circuit schematic diagram of a signal intensity regulating circuit according to Embodiment 4 of the present disclosure.

### DESCRIPTION OF THE PREFERRED EMBODIMENTS

Exemplary embodiments will be described in detail herein, and examples thereof are shown in the accompanying drawings. When the following description refers to the accompanying drawings, unless otherwise indicated, the same numbers in different drawings represent the same or similar elements. The implementation manners described in the following exemplary embodiments do not represent all implementation manners consistent with the present disclosure. Rather, they are merely examples of apparatuses and methods consistent with some aspects of the disclosure as detailed in the appended claims.

The terms used in the present disclosure are only for the purpose of describing particular embodiments and are not intended to be limiting of the present disclosure. The singular forms of "a", "said" and "the" used in the present application and the appended claims are also intended to include the plural forms, unless the context clearly indicates other meanings. It should also be understood that the term "and/or" used herein refers to and includes any and all possible combinations of one or more of the associated listed items.

It should be understood that although the terms first, second, third, etc. may be used in the present disclosure to describe various information, such information should not be limited to these terms. These terms are used only to distinguish information of the same type from one another. For example, without departing from the scope of the present disclosure, first information may also be referred to as second information, and similarly, second information may also be referred to as first information. Depending on the context, the words "if"/"in case" as used herein may be interpreted as "when...", "while..." or "in response to determining".

The signal regulating circuit in the original touch device is limited by the limited number of channels inside the analog switch chip, with few regulatable levels, unable to achieve more fine sampling signal regulation, and is not convenient to use.

In order to solve the above problems, the embodiments of the present disclosure provide a signal intensity regulating circuit, an infrared touch device and an electronic equipment. The signal intensity regulating circuit can make a more precise regulation on the sampled signal, and has a simple circuit structure and is easy to implement.

Hereinafter, embodiments of the technical solution of the present disclosure will be described in conjunction with the accompanying drawings.

According to a first aspect of an embodiment of the present disclosure, a signal intensity regulating circuit is provided. The signal intensity regulating circuit may be applied to an electronic equipment with a touch function to regulate the intensity of a touch signal when the touch signal of the electronic equipment is collected. The electronic equipment may be an interactive board, a smart blackboard, a smart whiteboard, a personal computer, an industrial computer, a smart home central control and other smart devices, and the touch signal may be an infrared touch signal or other touch signal.

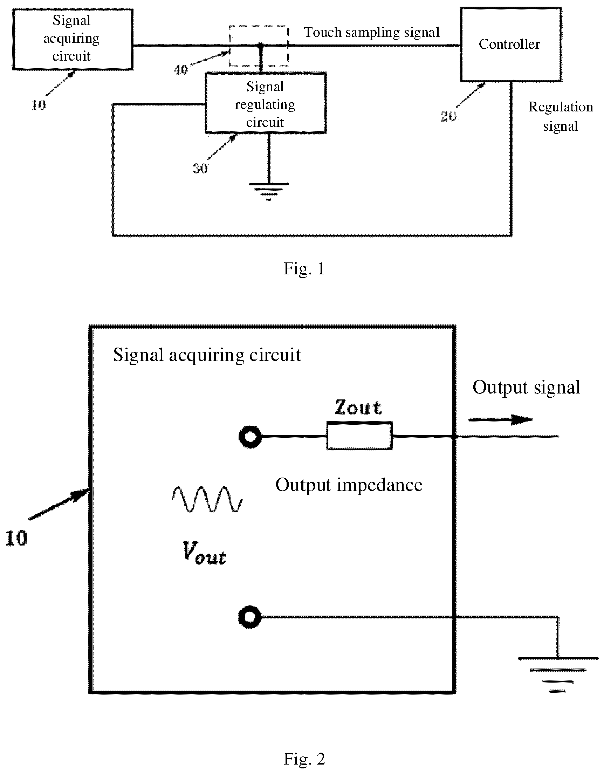

Referring to Fig. 1 and Fig. 2, Fig. 1 is a schematic block diagram of a signal intensity regulating circuit according to an embodiment of the present disclosure; and Fig. 2 is a schematic diagram of the output impedance of a signal acquiring circuit according to an embodiment of the present disclosure.

The signal intensity regulating circuit includes a signal acquiring circuit 10, a controller 20 and a signal regulating circuit 30; the signal regulating circuit 30 is connected between the signal acquiring circuit 10 and the controller 20. The signal acquiring circuit 10 is configured to obtain a touch sampling signal to be sampled. As shown in Fig. 2, the signal acquiring circuit 10 has a certain output impedance *Zout.*

The controller 20 may play a main control role, which may be a core processor of an electronic equipment, or a dedicated processor dedicated to realizing the touch function, and may generate a corresponding regulation signal for regulating the signal regulating circuit 30 based on the touch sampling signal received at the current moment, such as infrared, electromagnetic or capacitive touch signals. The controller 20 has a signal input end and a control end. The signal regulating circuit 30 is configured to regulate the intensity of the touch signal obtained by the signal acquiring circuit 10, and includes a switch element. The switch element may be a voltage-controlling switch element, when the controlled end (enable end) thereof receives different voltage signals, different on-resistances will be generated inside. The switch element has a first signal end, a second signal end and a controlled end; the first signal end of the switch element is connected to the signal output end of the signal acquiring circuit 10 and forms a signal voltage-dividing node 40, the signal voltage-dividing node 40 is connected to the signal input end of the controller 20, the second signal end of the switch element is connected to the reference power supply, and the controlled end of the switch element is connected to the control end of the controller 20; the controller 20 is configured to output a corresponding regulation signal to the controlled end of the switch element based on the touch sampling signal received at the current moment, and the switch element receives regulation signals of different intensities to generate on-resistances of different resistance values. The signal voltage-dividing node 40 forms a touch sampling signal at the next moment under the voltage dividing action of the output impedance of the signal acquiring circuit 10 and the on-resistance, that is, generates voltage sampling signals of different intensities and transmits them to the signal input end of the controller 20. The controller 20 then generates a corresponding regulation signal based on the touch sampling signal received in real time and outputs it to the controlled end of the switch element, thereby regulating the on-resistance of the switch element accordingly to change the intensity of the touch sampling signal at the next moment with high regulation accuracy.

As shown in Fig. 2, the output impedance of the signal acquiring circuit 10 is *Zout.* The output impedance ***Zout*** is very important for the signal acquiring circuit 10, which measures the output capability of the signal acquiring circuit 10. Optionally, in order to make the output impedance of the signal acquiring circuit 10 match the on-resistance of the switch element, the output impedance ***Zout*** may be within an optional range, such as between 10R and 1KΩ.

According to the technical solution of this embodiment, by providing a signal regulating circuit 30 for regulating the touch sampling signal intensity between the signal acquiring circuit 10 and the controller 20, the voltage of the touch sampling signal is regulated. When the controller 20 outputs regulation signals of different voltages, on-resistances of different resistance values are generated inside the switch element of the signal regulating circuit 30. The on-resistance and the output impedance of the signal acquiring circuit form a voltage dividing circuit, thereby dividing the touch sampling signal to be sampled and forming touch sampling signals of different intensities at the next moment at the signal voltage-dividing node 40. The voltage value at the signal voltage-dividing node 40 changes with the change of the regulation signal, thereby regulating the intensity of the touch sampling signal at the next moment with a relatively fine regulation degree.

In this embodiment, the signal acquiring circuit 10 may be a front-end signal regulating circuit, the front-end signal regulating circuit is connected to a touch sensor such as an infrared signal receiving unit, receives the touch sampling signal to be sampled, filters, amplifies, and processes it, and then transmits it to the controller 20 after being regulated by the signal regulating circuit 30.

The controller 20 is the main control device of the circuit. After receiving the touch sampling signal at the current moment, the controller 20 may control the operating device to execute the corresponding instruction so as to realize the corresponding touch function. The specific model of the controller 20 is not limited, and may be a processing device such as a single chip microcomputer.

Optionally, the controller 20 is configured to generate a corresponding regulation signal based on the touch sampling signal at the current moment and a preset target value, the preset target value may be a preset ideal sampling signal value. However, since the use environment and circuit, etc. may affect the touch sampling signal, it is necessary to generate a corresponding regulation signal based on the touch sampling signal at the current moment and the preset target value and transmit it to the controlled end of the switch element.

The reference power source connected to the second signal end of the switch element may be an auxiliary power source with a preset voltage value, such as a positive voltage or a negative voltage, or may be a zero potential auxiliary power source, that is, a reference ground (GND).

The switch element may be a voltage-controlling switch element, and when the controlled end (enabling end) thereof receives different voltage signals, different on-resistances will be generated inside the switch element.

In an optional embodiment, the voltage-controlling switch element may be a triode, a field effect triode, or other voltage-controlling switches. The triode includes an NPN triode and a PNP triode; the field effect triode includes an N-channel field effect triode and a P-channel field effect triode.

If the voltage-controlling switch element is a triode; a base of the triode is the controlled end of the switch element, one of a collector and an emitter of the triode is the first signal end of the switch element, and the other of the emitter and the collector of the triode is the second signal end of the switch element; one of the collector and the emitter of the triode is connected to the signal output end of the signal acquiring circuit to form a signal voltage-dividing node 40, the other of the emitter and the collector of the triode is connected to the reference power supply, and the base of the triode is connected to the control end of the controller.

If the voltage-controlling switch element is a field effect transistor; a gate of the field effect transistor is the controlled end of the switch element, one of a drain or a source of the field effect transistor is the first signal end of the switch element, and the other of the source or the drain of the field effect transistor is the second signal end of the switch element; one of the drain or the source of the field effect transistor is connected to the signal output end of the signal acquiring circuit to form a signal voltage-dividing node 40, the other of the source or the drain of the field effect transistor is connected to the reference power supply, and the gate of the field effect transistor is connected to the control end of the controller.

It should be noted that the voltage-controlling switch element has multiple states such as saturation, conduction and cutoff. In the embodiment of the present disclosure, the corresponding state may be selected according to the needs.

The following is a description of a specific embodiment of a voltage-controlling switch element.

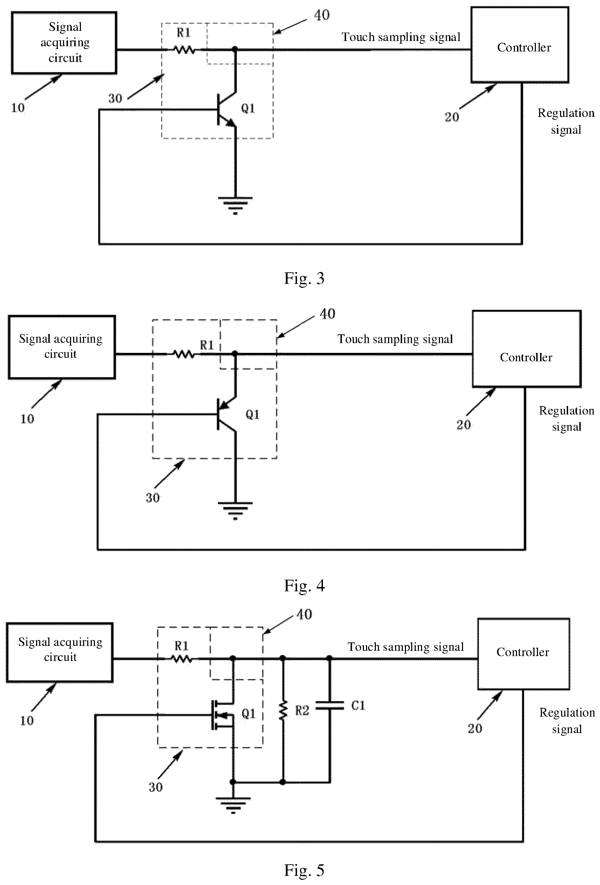

Referring to Fig. 3, Fig. 3 is a circuit schematic diagram of a signal intensity regulating circuit according to Embodiment 1 of the present disclosure.

In this embodiment, the voltage-controlling switch element is an NPN triode Q1.

The base B of the NPN triode Q1 is the controlled end of the switch element, the collector C of the NPN triode Q1 is the first signal end of the switch element, and the emitter E of the NPN triode Q1 is the second signal end of the switch element; the collector C of the NPN triode Q1 is connected to the signal output end of the signal acquiring circuit 10 and forms a signal voltage-dividing node 40, and the emitter E of the NPN triode Q1 is connected to the reference power supply, that is, ground; the base B of the NPN triode Q1 is connected to the control end of the controller 20 to receive the regulation signal.

When the controller 20 outputs regulation signals of different voltages, on-resistances of different resistances are generated inside the NPN triode Q1. The on-resistance and the output impedance of the signal acquiring circuit 10 form a voltage-dividing circuit, thereby dividing the touch sampling signal to be sampled and forming a touch sampling signal at the current moment with different voltage intensities at the signal voltage-dividing node 40. The voltage value at the signal voltage-dividing node 40 changes with the change of the regulation signal, thereby realizing the intensity regulation of the touch sampling signal at the current moment, and has a finer regulation degree, and the regulatable fineness is no longer limited by the number of channels of the analog switch chip.

In an optional embodiment, the voltage-controlling switch element is a PNP triode Q1.

Referring to Fig. 4, Fig. 4 is a circuit schematic diagram of a signal intensity regulating circuit according to Embodiment 2 of the present disclosure.

The base B of the PNP triode Q1 is the controlled end of the switch element, the emitter E of the PNP triode Q1 is the first signal end of the switch element, and the collector C of the PNP triode Q1 is the second signal end of the switch element; the emitter E of the PNP triode Q1 is connected to the signal output end of the signal acquiring circuit 10 and forms a signal voltage-dividing node 40, and the collector of the PNP triode Q1 is connected to the reference power supply, that is, ground; the base B of the PNP triode Q1 is connected to the control end of the controller 20 to receive the regulation signal.

When the controller 20 outputs regulation signals of different voltages, on-resistances of different resistances are generated inside the PNP triode Q1. The on-resistance and the output impedance of the signal acquiring circuit form a voltage-dividing circuit, thereby dividing the touch sampling signal to be sampled and forming a touch sampling signal of different voltage intensities at the current moment at the signal voltage-dividing node 40. The voltage value at the signal voltage-dividing node 40 changes with the change of the regulation signal, thereby realizing the intensity regulation of the touch sampling signal at the current moment, and has a finer regulation degree, and the regulatable fineness is no longer limited by the number of channels of the analog switch chip.

In an optional embodiment, the voltage-controlling switch element may be an N-channel field effect triode.

Referring to Fig. 5, Fig. 5 is a circuit schematic diagram of a signal intensity regulating circuit according to Embodiment 3 of the present disclosure.

The gate G of the N-channel field effect triode Q1 is the controlled end of the switch element, the drain D of the N-channel field effect triode Q1 is the first signal end of the switch element, and the source S of the N-channel field effect triode Q1 is the second signal end of the switch element; the drain D of the N-channel field effect triode Q1 is connected to the signal output end of the signal acquiring circuit 10 and forms a signal voltage-dividing node 40, the source S of the N-channel field effect triode Q1 is connected to the reference power supply (ground), and the gate G of the N-channel field effect triode Q1 is connected to the control end of the controller 20 to receive the regulation signal.

When the controller outputs regulation signals of different voltages, on-resistances of different resistances are generated inside the N-channel field effect triode Q1. The on-resistance and the output impedance at the back end of the signal acquiring circuit form a voltage-dividing circuit, thereby dividing the touch sampling signal to be sampled and forming a touch sampling signals of different intensities at the current moment at the signal voltage-dividing node 40. The voltage value at the signal voltage-dividing node 40 changes with the change of the regulation signal, thereby regulating the intensity of the touch sampling signal at the current moment with a relatively fine regulation degree, and the regulatable fineness is no longer limited by the number of channels of the analog switch chip.

In an optional embodiment, the voltage-controlling switch element may be a P-channel field effect triode.

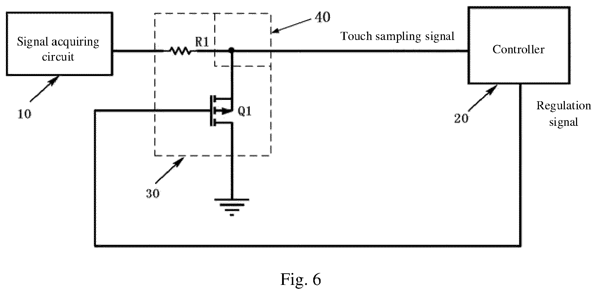

Referring to Fig. 6, Fig. 6 is a circuit schematic diagram of a signal intensity regulating circuit according to Embodiment 4 of the present disclosure.

The gate G of the P-channel field effect triode Q1 is the controlled end of the switch element, the source S of the P-channel field effect triode Q1 is the first signal end of the switch element, and the drain D of the P-channel field effect triode Q1 is the second signal end of the switch element; the source S of the P-channel field effect triode Q1 is connected to the signal output end of the signal acquiring circuit 10 and forms a signal voltage-dividing node 40, the drain D of the P-channel field effect triode Q1 is connected to the reference power supply (ground), and the gate G of the P-channel field effect triode Q1 is connected to the control end of the controller 20 to receive the regulation signal.

When the controller 20 outputs regulation signals of different voltages, on-resistances of different resistances are generated inside the P-channel field effect triode Q1. The on-resistance and the output impedance of the signal acquiring circuit form a voltage-dividing circuit, thereby dividing the touch sampling signal to be sampled and forming voltage sampling signals of different intensities at the signal voltage-dividing node 40. The voltage value at the signal voltage-dividing node 40 changes with the change of the regulation signal, thereby achieving intensity regulation of the touch sampling signal at the current moment with a relatively fine regulation degree, and the regulatable fineness is no longer limited by the number of channels of the analog switch chip.

In an optional embodiment, as shown in Figs. 3 to 6, the signal regulating circuit 30 further includes a first resistor R1, the first resistor R1 is connected between the output end of the signal acquiring circuit 10 and the signal voltage-dividing node 40; the first resistor R1 is connected in series with the switch element Q1. If the internal output impedance of the signal acquiring circuit 10 is small and may be ignored, the on-resistance generated by the switch element Q1 and the first resistor R1 divide the touch sampling signal output by the signal acquiring circuit. If the internal output impedance of the signal acquiring circuit 10 is relatively large, the on-resistance generated by the switch element Q1, the first resistor R1, and the output impedance *Zout* divide the touch sampling signal to be sampled output by the signal acquiring circuit 10.

In order to make the first resistor R1 match the on-resistance of the switch element, the resistance of the first resistor R1 may be within an optional range, such as between 10R and 1KΩ.

The first resistor R1 may be a fixed resistor or an regulatable resistor. If the first resistor R1 is an regulatable resistor, the user may also regulate the signal regulation intensity by regulating the actual resistance value of the first resistor R1, which is more flexible to use.

Optionally, the first resistor R1 may be disposed inside or outside the signal acquiring circuit 10, which is not limited in this embodiment.

When the controller 20 outputs regulation signals of different magnitudes, the on-resistance of the switch element Q1 will change when it is in various states. Therefore, if the internal output impedance of the signal acquiring circuit 10 may be ignored, the touch sampling signal to be sampled will be divided under the action of the first resistor R1 and the on-resistance of the switch element Q1, and the regulated sampling signal is obtained at the signal voltage-dividing node 40 and transmitted to the controller 20. During voltage division, the ratio of the on-resistance of the first resistor R1 to the on-resistance of the switch element Q1 will affect the magnitude of the touch sampling signal at the next moment, thereby achieving intensity regulation of the touch sampling signal at the next moment.

In an optional embodiment, as shown in Fig. 5, a filter circuit is connected in parallel between the first signal end and the second signal end of the switch element Q1. The filter circuit includes a second resistor R2 and a first capacitor C1, and can filter the current touch sampling signal output by the signal voltage-dividing node 40 to improve the quality.

According to the signal intensity regulating circuit described in the above embodiment, by providing a signal regulating circuit for regulating the touch sampling signal intensity between the signal acquiring circuit and the controller, the voltage of the touch sampling signal is regulated. When the controller outputs regulation signals of different voltages, on-resistances of different resistance values are generated inside the switch element of the signal regulating circuit. The on-resistance and the output impedance of the signal acquiring circuit form a voltage dividing circuit, thereby dividing the touch sampling signal to be sampled and forming touch sampling signals of different intensities at the next moment at the signal voltage-dividing node. The voltage value at the signal voltage-dividing node changes with the change of the regulation signal, thereby regulating the intensity of the touch sampling signal at the next moment with a relatively fine regulation degree, and the circuit structure is simple and easy to implement.

According to a second aspect of the embodiments of the present disclosure, an infrared touch device is provided, which includes a touch signal receiving unit and a signal intensity regulating circuit as described in the previous embodiments.

The touch signal receiving unit is electrically connected to the signal intensity regulating circuit. After receiving the touch signal, the touch signal receiving unit transmits it to the signal acquiring circuit for pre-stage signal processing, and then transmits it to the signal regulating circuit for signal intensity regulation. Finally, the voltage sampling signal after intensity regulation is transmitted to the controller so that the controller controls the execution device to perform corresponding actions.

According to a third aspect of an embodiment of the present disclosure, an electronic equipment is provided, which includes an operating device and a touch control device as described in the previous embodiment.

The electronic equipment may be an interactive board with a touch function, a smart blackboard, a smart whiteboard, a personal computer, an industrial computer, a smart home central control, or other electronic equipment, which is not limited in this embodiment.

The operating device may be a display screen or other execution components.

According to the electronic equipment described in the above embodiment, by providing a signal regulating circuit for regulating the touch sampling signal intensity between the signal acquiring circuit and the controller, the voltage of the touch sampling signal is regulated. When the controller outputs regulation signals of different voltages, on-resistances of different resistance values are generated inside the switch element of the signal regulating circuit. The on-resistance and the output impedance of the signal acquiring circuit form a voltage dividing circuit, thereby dividing the touch sampling signal to be sampled and forming touch sampling signals of different intensities at the next moment at the signal voltage-dividing node. The voltage value at the signal voltage-dividing node changes with the change of the regulation signal, thereby regulating the intensity of the touch sampling signal at the next moment with a relatively fine regulation degree, and the circuit structure is simple and easy to implement.

The above embodiments only express several implementation manners of the present disclosure, and the description thereof is relatively specific and detailed, but it should not be understood as limiting the scope of the invention patent. The invention is defined by the appended claims.

## Claims

1. A signal intensity regulating circuit, comprising: a signal acquiring circuit (1), a controller (2) and a signal regulating circuit (3); wherein the signal regulating circuit (3) is connected between the signal acquiring circuit (1) and the controller (2); the controller (2) has a signal input end (2a) and a control end (2b);
the signal regulating circuit (3) includes a switch element (4), the switch element (4) has a first signal end (4a), a second signal end (4b) and a controlled end (4c);
the first signal end (4a) of the switch element (4) is connected to a signal output end of the signal acquiring circuit (1) to form a signal voltage-dividing node (5), the signal voltage-dividing node (5) is connected to the signal input end (2a) of the controller (2), the second signal end (4b) of the switch element (4) is connected to a reference power supply (6), and the controlled end (4c) of the switch element (4) is connected to the control end (2b) of the controller (2);
the controller (2) is configured to output a corresponding regulation signal to the controlled end (4c) of the switch element (4) based on the touch sampling signal received at the current moment, the switch element (4) is configured to generate a corresponding on-resistance based on the regulation signal, **characterized in that** the signal voltage-dividing node (5) is configured to form a touch sampling signal at the next moment under the voltage-dividing action of the output impedance of the signal acquiring circuit (1) and the on-resistance, and transmit the touch sampling signal to the signal input end (2a) of the controller (2).

2. The signal intensity regulating circuit of claim 1, wherein the switch element (4) is a voltage-controlling switch element.

3. The signal intensity regulating circuit of claim 2, wherein the voltage-controlling switch element (4) is a triode, a base of the triode is the controlled end (4c) of the switch element (4), one of a collector or an emitter of the triode is the first signal end (4a) of the switch element (4), and the other of the emitter or the collector of the triode is the second signal end (4b) of the switch element (4); one of the collector or the emitter of the triode is connected to the signal output end of the signal acquiring circuit (1) to form a signal voltage-dividing node, the other of the emitter or the collector of the triode is connected to the reference power supply (6), and the base of the triode is connected to the control end (2b) of the controller (2).

4. The signal intensity regulating circuit of claim 2, wherein the voltage-controlling switch element (4) is a field effect transistor; a gate of the field effect transistor is the controlled end (4c) of the switch element (4), one of a drain or a source of the field effect transistor is the first signal end (4a) of the switch element (4), and the other of the source or the drain of the field effect transistor is the second signal end (4b) of the switch element (4);
one of the drain or the source of the field effect transistor is connected to the signal output end of the signal acquiring circuit (1) to form a signal voltage-dividing node (5), the other of the source or the drain of the field effect transistor is connected to the reference power supply (6), and the gate of the field effect transistor is connected to the control end (2b) of the controller (2).

5. The signal intensity regulating circuit of claim 1, wherein the signal regulating circuit (3) further includes a first resistor (7), the first resistor (7) is connected between the output end of the signal acquiring circuit (1) and the signal voltage-dividing node (5); the first resistor (7) is connected in series with the switch element (4), the on-resistance generated by the switch element (4) and the output impedance of the signal acquiring circuit (1) and the first resistor (7) divide the touch sampling signal to be sampled output by the signal acquiring circuit (1).

6. The signal intensity regulating circuit of claim 1, wherein a filter circuit (8) is connected in parallel between the first signal end (4a) and the second signal end (4b) of the switch element (4).

7. The signal intensity regulating circuit of claim 1, wherein the reference power provided by the reference power supply (6) is a positive voltage or a negative voltage, or a reference ground.

8. The signal intensity regulating circuit of any one of claims 1-7, wherein the controller (2) is configured to generate a corresponding regulation signal based on the touch sampling signal at the current moment and a preset target value.

9. An infrared touch device (9), comprising an infrared signal receiving unit (10) and the signal intensity regulating circuit of any one of claims 1-8.

10. An electronic equipment, comprising an operating device (11) and the infrared touch device (9) of claim 9.

## Patentansprüche

1. Signalintensitätsregelschaltung, umfassend: eine Signalerfassungsschaltung (1), eine Steuerung (2) und eine Signalregelschaltung (3);
wobei die Signalregelschaltung (3) zwischen der Signalerfassungsschaltung (1) und der Steuerung (2) verbunden ist;
die Steuerung (2) ein Signaleingangsende (2a) und ein Steuerende (2b) aufweist;
die Signalregelschaltung (3) ein Schaltelement (4) einschließt, das Schaltelement (4) ein erstes Signalende (4a), ein zweites Signalende (4b) und ein gesteuertes Ende (4c) aufweist;
das erste Signalende (4a) des Schaltelements (4) mit einem Signalausgangsende der Signalerfassungsschaltung (1) verbunden ist, um einen Signalspannungsteilerknoten (5) auszubilden,
der Signalspannungsteilerknoten (5) mit dem Signaleingangsende (2a) der Steuerung (2) verbunden ist, das zweite Signalende (4b) des Schaltelements (4) mit einer Referenzstromversorgung (6) verbunden ist und das gesteuerte Ende (4c) des Schaltelements (4) mit dem Steuerende (2b) der Steuerung (2) verbunden ist;
die Steuerung (2) konfiguriert ist, um basierend auf dem zu dem aktuellen Zeitpunkt empfangenen Berührungsabtastsignal ein entsprechendes Regelsignal an das gesteuerte Ende (4c) des Schaltelements (4) auszugeben, das Schaltelement (4) konfiguriert ist, um basierend auf dem Regelsignal einen entsprechenden Einschaltwiderstand zu erzeugen, **dadurch gekennzeichnet, dass** der Signalspannungsteilerknoten (5) konfiguriert ist, um zu dem nächsten Zeitpunkt unter der Spannungsteilerwirkung der Ausgangsimpedanz der Signalerfassungsschaltung (1) und des Einschaltwiderstands ein Berührungsabtastsignal auszubilden und das Berührungsabtastsignal an das Signaleingangsende (2a) der Steuerung (2) zu übertragen.

2. Signalintensitätsregelschaltung nach Anspruch 1, wobei das Schaltelement (4) ein spannungssteuerndes Schaltelement ist.

3. Signalintensitätsregelschaltung nach Anspruch 2, wobei das spannungssteuernde Schaltelement (4) eine Triode ist, eine Basis der Triode das gesteuerte Ende (4c) des Schaltelements (4) ist, einer von einem Kollektor oder einem Emitter der Triode das erste Signalende (4a) des Schaltelements (4) ist und der andere von dem Emitter oder dem Kollektor der Triode das zweite Signalende (4b) des Schaltelements (4) ist;
einer von dem Kollektor oder dem Emitter der Triode mit dem Signalausgangsende der Signalerfassungsschaltung (1) verbunden ist, um einen Signalspannungsteilerknoten auszubilden, der andere von dem Emitter oder dem Kollektor der Triode mit der Referenzstromversorgung (6) verbunden ist und die Basis der Triode mit dem Steuerende (2b) der Steuerung (2) verbunden ist.

4. Signalintensitätsregelschaltung nach Anspruch 2, wobei das spannungssteuernde Schaltelement (4) ein Feldeffekttransistor ist; ein Gate des Feldeffekttransistors das gesteuerte Ende (4c) des Schaltelements (4) ist, eines von einem Drain oder einer Source des Feldeffekttransistors das erste Signalende (4a) des Schaltelements (4) ist und das andere von der Source oder dem Drain des Feldeffekttransistors das zweite Signalende (4b) des Schaltelements (4) ist;
eines von dem Drain oder der Source des Feldeffekttransistors mit dem Signalausgangsende der Signalerfassungsschaltung (1) verbunden ist, um einen Signalspannungsteilerknoten (5) auszubilden,
das andere von der Source oder dem Drain des Feldeffekttransistors mit der Referenzstromversorgung (6) verbunden ist und das Gate des Feldeffekttransistors mit dem Steuerende (2b) der Steuerung (2) verbunden ist.

5. Signalintensitätsregelschaltung nach Anspruch 1, wobei die Signalregelschaltung (3) ferner einen ersten Widerstand (7) einschließt, der erste Widerstand (7) zwischen dem Ausgangsende der Signalerfassungsschaltung (1) und dem Signalspannungsteilerknoten (5) verbunden ist; der erste Widerstand (7) mit dem Schaltelement (4) in Reihe verbunden ist, der durch das Schaltelement (4) erzeugte Einschaltwiderstand und die Ausgangsimpedanz der Signalerfassungsschaltung (1) und der erste Widerstand (7) das durch die Signalerfassungsschaltung (1) ausgegebene abzutastende Berührungsabtastsignal teilen.

6. Signalintensitätsregelschaltung nach Anspruch 1, wobei eine Filterschaltung (8) zwischen dem ersten Signalende (4a) und dem zweiten Signalende (4b) des Schaltelements (4) parallel verbunden ist.

7. Signalintensitätsregelschaltung nach Anspruch 1, wobei der durch die Referenzstromversorgung (6) bereitgestellte Referenzstrom eine positive Spannung oder eine negative Spannung oder eine Referenzmasse ist.

8. Signalintensitätsregelschaltung nach einem der Ansprüche 1 bis 7, wobei die Steuerung (2) konfiguriert ist, um basierend auf dem Berührungsabtastsignal zu dem aktuellen Zeitpunkt und einem voreingestellten Zielwert ein entsprechendes Regelsignal zu erzeugen.

9. Infrarotberührungsvorrichtung (9), umfassend eine Infrarotsignalempfangseinheit (10) und die Signalintensitätsregelschaltung nach einem der Ansprüche 1 bis 8.

10. Elektronische Ausrüstung, umfassend eine Betriebsvorrichtung (11) und die Infrarotberührungsvorrichtung (9) nach Anspruch 9.

## Revendications

1. Circuit de régulation d'intensité de signal, comprenant : un circuit d'acquisition de signal (1), un dispositif de commande (2) et un circuit de régulation de signal (3) ;
dans lequel le circuit de régulation de signal (3) est connecté entre le circuit d'acquisition de signal (1) et le dispositif de commande (2) ;
le dispositif de commande (2) a une extrémité d'entrée de signal (2a) et une extrémité de commande (2b) ;
le circuit de régulation de signal (3) comporte un élément de commutation (4), l'élément de commutation (4) a une première extrémité de signal (4a), une seconde extrémité de signal (4b) et une extrémité commandée (4c) ;
la première extrémité de signal (4a) de l'élément de commutation (4) est connectée à une extrémité de sortie de signal du circuit d'acquisition de signal (1) pour former un nœud de division de tension de signal (5),
le nœud de division de tension de signal (5) est connecté à l'extrémité d'entrée de signal (2a) du dispositif de commande (2), la seconde extrémité de signal (4b) de l'élément de commutation (4) est connectée à une alimentation électrique de référence (6), et l'extrémité commandée (4c) de l'élément de commutation (4) est connectée à l'extrémité de commande (2b) du dispositif de commande (2) ;
le dispositif de commande (2) est configuré pour délivrer en sortie un signal de régulation correspondant à l'extrémité commandée (4c) de l'élément de commutation (4) sur la base du signal d'échantillonnage tactile reçu au moment actuel, l'élément de commutation (4) est configuré pour générer une résistance à l'état passant correspondante sur la base du signal de régulation,
**caractérisé en ce que** le nœud de division de tension de signal (5) est configuré pour former un signal d'échantillonnage tactile au moment suivant sous l'action de division de tension de l'impédance de sortie du circuit d'acquisition de signal (1) et de la résistance à l'état passant, et transmettre le signal d'échantillonnage tactile à l'extrémité d'entrée de signal (2a) du dispositif de commande (2).

2. Circuit de régulation d'intensité de signal selon la revendication 1, dans lequel l'élément de commutation (4) est un élément de commutation à commande en tension.

3. Circuit de régulation d'intensité de signal selon la revendication 2, dans lequel l'élément de commutation à commande en tension (4) est une triode, une base de la triode est l'extrémité commandée (4c) de l'élément de commutation (4), l'un parmi un collecteur ou un émetteur de la triode est la première extrémité de signal (4a) de l'élément de commutation (4), et l'autre de parmi l'émetteur ou le collecteur de la triode est la seconde extrémité de signal (4b) de l'élément de commutation (4) ;
l'un parmi le collecteur ou l'émetteur de la triode est connecté à l'extrémité de sortie de signal du circuit d'acquisition de signal (1) pour former un nœud de division de tension de signal, l'autre parmi l'émetteur ou le collecteur de la triode est connecté à l'alimentation électrique de référence (6), et la base de la triode est connectée à l'extrémité de commande (2b) du dispositif de commande (2).

4. Circuit de régulation d'intensité de signal selon la revendication 2, dans lequel l'élément de commutation à commande en tension (4) est un transistor à effet de champ ; une grille du transistor à effet de champ est l'extrémité commandée (4c) de l'élément de commutation (4), l'un parmi un drain ou une source du transistor à effet de champ est la première extrémité de signal (4a) de l'élément de commutation (4), et l'autre parmi la source ou le drain du transistor à effet de champ est la seconde extrémité de signal (4b) de l'élément de commutation (4) ;
l'un parmi le drain ou la source du transistor à effet de champ est connecté à l'extrémité de sortie de signal du circuit d'acquisition de signal (1) pour former un nœud de division de tension de signal (5),
l'autre parmi la source ou le drain du transistor à effet de champ est connecté à l'alimentation électrique de référence (6), et la grille du transistor à effet de champ est connectée à l'extrémité de commande (2b) du dispositif de commande (2).

5. Circuit de régulation d'intensité de signal selon la revendication 1, dans lequel le circuit de régulation de signal (3) comporte en outre une première résistance (7), la première résistance (7) est connectée entre l'extrémité de sortie du circuit d'acquisition de signal (1) et le nœud de division de tension de signal (5) ; la première résistance (7) est connectée en série avec l'élément de commutation (4), la résistance à l'état passant générée par l'élément de commutation (4) et l'impédance de sortie du circuit d'acquisition de signal (1) et la première résistance (7) divisent le signal d'échantillonnage tactile à échantillonner délivré en sortie par le circuit d'acquisition de signal (1).

6. Circuit de régulation d'intensité de signal selon la revendication 1, dans lequel un circuit filtrant (8) est connecté en parallèle entre la première extrémité de signal (4a) et la seconde extrémité de signal (4b) de l'élément de commutation (4).

7. Circuit de régulation d'intensité de signal selon la revendication 1, dans lequel l'alimentation électrique de référence fournie par l'alimentation électrique de référence (6) est une tension positive ou une tension négative, ou une masse de référence.

8. Circuit de régulation d'intensité de signal selon l'une quelconque des revendications 1 à 7, dans lequel le dispositif de commande (2) est configuré pour générer un signal de régulation correspondant sur la base du signal d'échantillonnage tactile au moment actuel et d'une valeur cible prédéfinie.

9. Dispositif tactile infrarouge (9), comprenant une unité de réception de signal infrarouge (10) et le circuit de régulation d'intensité de signal selon l'une quelconque des revendications 1 à 8.

10. Équipement électronique, comprenant un dispositif de commande (11) et le dispositif tactile infrarouge (9) selon la revendication 9.
